# EUROPÄISCHE PATENTANMELDUNG

(11) **EP 4 585 322 A1**
(43) Veröffentlichungstag der Anmeldung: **16.07.2025**
(21) Anmeldenummer: 24151298.7
(22) Anmeldetag: 11.01.2024
(51) Int. Cl.: B21B 27/00, C23C 4/067, C23C 4/10, C23C 4/129, C23C 14/06, C23C 14/34

(54) **WALZE MIT EINER ZUMINDEST BEREICHSWEISE APPLIZIERTEN VERSCHLEISSSCHUTZSCHICHT UND ENTSPRECHENDE VERWENDUNG**

(71) Anmelder: ThyssenKrupp Steel Europe AG, 47166 Duisburg (DE)
(72) Erfinder: Bienholz, Stefan, 44795 Bochum (DE); Fork, Pia, 41468 Neuss (DE); Karakavaf, Stephan, 46537 Dinslaken (DE); Henke, Juline, 45355 Essen (DE); Rezanka, Stefan, 41199 Mönchengladbach (DE)
(74) Vertreter: ThyssenKrupp Steel Europe AG

(57) **Zusammenfassung**

Die Erfindung betrifft eine Walze (1) mit einer zumindest bereichsweise applizierten Verschleißschutzschicht (2) mit einer Mindesthärte von 700 HV0,01 und eine entsprechende Verwendung.

## Beschreibung

Die Erfindung betrifft eine Walze mit einer zumindest bereichsweise applizierten Verschleißschutzschicht und eine entsprechende Verwendung.

Die Rauheiten von Walzen können, je nach Gerüst in einem Walzwerk, in einem Bereich liegen, damit sich ein für die Fertigung günstiges Prozessfenster ergibt. Sie können somit nicht zu glatt und nicht zu rau sein. Diese werden meist durch die Parameter Ra bzw. Sa und Rz bzw. Sz beschrieben. Reibung wird für die Greifbedingung benötigt, damit das Bandmaterial von der Walze im Eingang des Walzspaltes gegriffen und zwischen die Walzen durchgetrieben wird. Des Weiteren kann eine ausreichend hohe Spitzenzahl, gemessen bzw. angegeben als RPc-Wert, bzw. Spitzendichte (Spd), gute Greifbedingungen gewähren.

Bekannt ist auch, dass eine hohe Schleifrauheit den Vorteil einer langen Walzstandzeit bieten kann, aber auch eine größere Neigung zur Bandverschmutzung. So darf die Rauheit der Walze nicht zu hoch gewählt werden, da so für Bandschmutz anfällige Werkstoffe erst zum Lebensende einer Walzenoberfläche prozessiert werden können, wenn die Rauheit durch den Walzprozess bereits reduziert ist.

Hintergrund der konventionellen Beschichtung von Walzen ist, dass die Mantel-/Oberflächen der Walzen durch das Aufbringen einer metallischen Schutzschicht, z. B. Hartverchromung, einen verbesserten Verschleißschutz in Bezug auf Standzeiten sowie einen positiven Einfluss auf die entsprechend geforderte Band-Sauberkeit bieten kann.

Aus der WO 2021/148690 A1 ist beispielhaft eine Walze bekannt, welche eine aufgespritzte Verschleißschutzschicht basierend auf einer Wolframkarbid-Legierung enthaltend Bestandteile aus Chromkarbiden oder Molybdänboriden mit einer Dicke zwischen 3 und 20 µm aufweist sowie ein entsprechendes Verfahren zu ihrer Herstellung. Ferner offenbart die EP 3 394 311 B1 eine Walze mit einer lokal thermisch gespritzten Verschleißschutzschicht, welche nicht dicker als 25 µm ist.

Alternativ zu dem oben beschriebenen Hochgeschwindigkeitsflammspritzen, auch HVOF genannt, ist aus der DE 40 06 550 C1 ein Verfahren zur verschleißfesten Ausrüstung einer Arbeitsfläche von auf der Arbeitsfläche mit einer Textur versehenen Walzen und Rollen für die Umformung und Verarbeitung von Stahl und andere Werkstoffen, bekannt, wobei u.a. im PVD-Verfahren oder auch im CVD-Verfahren eine Hartstoffbeschichtung aufgebracht werden kann.

Weitere Verfahren zur verschleißfesten Ausrüstung einer Walzenoberfläche sind das Laserauftragsschweißen, die elektrolytische Beschichtung oder das heißisostatische Pressen (HIP).

Der aktuelle Trend bei Strukturbauteilen geht zu immer höheren Festigkeiten bei Stahlwerkstoffen. Die dadurch vermehrt zum Einsatz kommenden Legierungselemente sorgen in Kombination mit Bandverschmutzung aus beispielsweise einem Kaltwalzprozess zu Problemen bei der Benetzbarkeit, beispielsweise im Schmelztauchbeschichtungsprozess.

Daher war es die Aufgabe, die Oberfläche der mit einer Verschleißschutzschicht beschichteten Walzen im stark verformenden Gerüst eines Walzwerkes dahingehend zu optimieren, dass es zu verbesserten Greifbedingungen der Walzen an der Bandoberfläche kommen kann und damit insbesondere die Bandsauberkeit erhöht werden kann.

Die beschriebene Verschleißschutzschicht verleiht der Walze, welche sowohl in einem Gerüst eines Warmwalz- oder bevorzugt Kaltwalzwerks, als auch in einem Nachwalz- oder Dressierwerk einsetzbar ist, die nötige Standzeit, die erforderlich ist, um unter industriellen Bedingungen Walzungen durchführen zu können.

Um einen guten Reibbeiwert (Greifbedingung) bei gleichzeitig geringer Bandverschmutzung zu erzielen, haben die Erfinder überraschenderweise festgestellt, dass die Topografie der Walzen eine definierte Charakterisierung haben muss. Walzen benötigen neben einer Struktur zum Greifen des Bandes zusätzlich auch Schmiertaschen zum Fördern der Walzemulsion in den Walzspalt.

Auf der Mantelfläche der Walze wird nach einem entsprechendem Bearbeitungsschritt, einem Texturieren, einem Schleifen oder beidem, zumindest bereichsweise eine Verschleißschutzschicht appliziert. Dies kann bei Bedarf bereichsweise erfolgen, wobei mindestens 20 %, 30 %, 40 %, insbesondere mindestens 50 %, 60 %, vorzugsweise mindestens 70 %, 80 % der Gesamtmantelfläche der Walze mit einer Verschleißschutzschicht bedeckt ist, wobei diese auch vollständig, somit die gesamte Mantelfläche der Walze, mit einer Verschleißschutzschicht bedeckt sein kann, insbesondere bis zu 98 %, vorzugsweise bis zu 95 % der Gesamtmantelfläche der Walze.

Das Texturieren von Walzen ist allgemein Stand der Technik. Dabei können unterschiedliche Technologien zur Anwendung kommen. Diese Texturen können unter anderem mit einem SBT-Verfahren (Shot Blasting Texturing), EDT-Verfahren (Electro Discharge Texturing), EBT-Verfahren (Electron-Beam-Texturing), Lasertexturierungsverfahren, Schleifstrukturen oder aber auch mit dem ECD-Verfahren (Electrical Chrome Deposition) aufgebracht werden. Bei diesen genannten Verfahren handelt es sich um ein Aufbringen einer stochastischen Oberflächentopographie auf Arbeitswalzen. Das EBT-Verfahren ermöglicht auch ein Aufbringen einer nicht stochastischen, also deterministischen Textur. Auch das LT-Verfahren (Laser Texturing) bietet die Möglichkeit, eine nicht stochastische, also deterministische Textur aufzubringen.

Das alternative oder zusätzliche Schleifen von Walzen ist ebenfalls Stand der Technik. Dabei können ebenfalls unterschiedliche Technologien zur Anwendung kommen. Die gängigste ist die Verwendung eines Schleifsteins oder Schleifbands mit einer bestimmten Körnung, insbesondere zwischen 30 und 180, vorzugsweise nach FEPA F oder P, um die Mantelfläche der Walzen zu bearbeiten.

Die applizierte Verschleißschutzschicht kann vergleichbare Oberflächen-Kennwerte wie die Mantelfläche, auf die sie appliziert wird, aufweisen. In der Regel liegen jedoch andere Kennwerte vor, auch wenn die Verschleißschutzschicht der Oberflächenstruktur der Mantelfläche im Wesentlichen folgt.

Die Verschleißschutzschicht weist eine Mindesthärte von 700 HV0,01 auf. Sie kann insbesondere mindestens 720 HV0,01, 740 HV0,01, vorzugsweise mindestens 820 HV0,01, 840 HV0,01, bevorzugt mindestens 850 HV0,01, 870 HV0,01 betragen. Maximal kann eine Härte bis zu 3000 HV0,01 vorliegen. Die Härte ergibt sich im Wesentlichen aus dem applizierten Werkstoff bzw. aus der applizierten Legierung. HV0,01 wird ermittelt nach DIN EN ISO 6507-1:2018-07.

Um die Oberfläche der Verschleißschutzschicht sinnvoll zu quantifizieren, sind die reduzierte Spitzenhöhe Spk und die reduzierte Talsohlentiefe Svk als charakteristische Kenngrößen sehr gut geeignet, vgl. insbesondere Kapitel **4.5.4.5** und **4.5.4.5** in Verbindung mit Anhang B, **B.3** in der DIN EN ISO 25178-2:2023-09.

Mithin weist die Oberfläche der Verschleißschutzschicht charakteristische Kenngrößen mit Spk > 1,20 µm und Svk > 1,20 µm auf, ermittelt nach DIN EN ISO 25178-2:2023-09.

Spk wird verwendet, um hervorstehende Spitzen zu charakterisieren, die während der Funktion eliminiert werden. Versuche haben gezeigt, dass Spk ein geeignetes Maß für das Greifvermögen darstellen kann. Je höher dieser Wert ist, desto besser kann die Walze das Metallband fördern, ohne dass es zum Rutschen - Geschwindigkeit des Metallbandes weicht von Geschwindigkeit der Walze ab - kommen kann.

Svk wird verwendet, um Täler zu charakterisieren, die Schmiermittel und/oder abgenutzte Materialien zurückhalten. Ein hoher Svk wird beispielsweise benötigt, um Walzemulsion in den Walzspalt zu fördern und somit den Bandschmutz reduzieren zu können.

Ein stabiler Walzprozess ohne Rutschen (Greifbedingung) mit geringem Bandschmutz kann somit nur dann gewährleistet werden, wenn die beiden Bedingungen für Spk und Svk erfüllt sind.

Die reduzierte Spitzenhöhe Spk kann insbesondere mindestens 1,3 µm, 1,4 µm, vorzugsweise mindestens 1,5 µm, 1,6 µm, bevorzugt mindestens 1,7 µm, 1,8 µm betragen. Der maximale Wert kann bis zu 10 µm, 9 µm, insbesondere bis zu 8 µm, 7 µm, vorzugsweise bis zu 6 µm, 5 µm betragen.

Die reduzierte Talsohlentiefe Svk kann insbesondere mindestens 1,3 µm, 1,4 µm, vorzugsweise mindestens 1,5 µm, 1,6 µm, bevorzugt mindestens 1,7 µm, 1,8 µm betragen. Der maximale Wert kann bis zu 10 µm, 9 µm, insbesondere bis zu 8 µm, 7 µm, vorzugsweise bis zu 6 µm, 5 µm betragen.

Walzen bestehen üblicherweise aus Metall, beispielsweise werden sie geschmiedet oder gegossen. In der Regel kommen Stahllegierungen zum Einsatz, sogenannte Arbeitsstähle. Welche Legierungen dafür in Frage kommen, ist der Fachwelt bekannt.

Das zu walzende Material ist vorzugsweise allgemein ein Stahl(flach)produkt. Alternativ kann es auch ein Aluminium(flach)produkt oder ein NE(Nicht Eisen)-Material sein.

Grundvoraussetzung ist, dass die Walze, sprich entweder, wenn sie neu hergestellt ist, mit einer zumindest bereichsweise zu beschichtenden Verschleißschutzschicht oder im Normalfall, wenn sie verschlissen aus dem Walzwerk kommt und damit wieder mit einer zumindest bereichsweise zu beschichtenden Verschleißschutzschicht versehen wird, eine Mantelfläche umfasst, welche eine Materialanteilkurve, auch als Abbott-Firestone-Kurve bezeichnet, mit einem Wendepunkt aufweist, somit eine S-förmige Materialanteilkurve hat, vgl. Kapitel 4.5 Materialanteilfunktionen und damit zusammenhängende Kenngrößen in der DIN EN ISO 25178-2:2023-09. Dem Fachmann ist geläufig, wie er ein Bearbeitungsschritt durchzuführen hat, beispielsweise durch die Einstellung des Beschichtungsprozesses selbst, ein Texturieren und/oder Schleifen, um eine vorzugsweise S-förmige Materialanteilkurve zu erzeugen. Die Mantelfläche kann einen arithmetischen Mittelwert der Höhe Sa, vgl. Kapitel 4.2.8 in der DIN EN ISO 25178-2:2023-09, von mindestens 0,2 µm, 0,3 µm, 0,4 µm, insbesondere von mindestens 0,5 µm, 0,6 µm, 0,7 µm, 0,8 µm, vorzugsweise von mindestens 0,9 µm, 1,0 µm, 1,1 µm, 1,2 µm, bevorzugt von mindestens 1,3 µm, 1,4 µm, 1,5 µm, 1,6 µm aufweisen. Maximal kann der arithmetische Mittelwert der Höhe Sa 10 µm, 9 µm, 8 µm, insbesondere maximal 7 µm, 6 µm, vorzugsweise maximal 5 µm, 4 µm betragen.

Die Verschleißschutzschicht kann eine Dicke zwischen 3 und 350 µm aufweisen. Je Bedarf kann diese gezielt vorgesehen und/oder eingestellt werden. Die Dicke kann insbesondere mindestens 4 µm, 5 µm, vorzugsweise mindestens 6 µm, 7 µm, bevorzugt mindestens 8 µm, 9 µm betragen. Die Dicke kann insbesondere auf maximal 290 µm, 200 µm, vorzugsweise auf maximal 140 µm, 90 µm, bevorzugt auf maximal 65 µm, 42 µm beschränkt sein.

Die Verschleißschutzschicht kann gemäß einer Ausführung mittels PVD appliziert sein. Der PVD-Prozess ist als solcher bekannt und damit Stand der Technik. Als besonders geeignet sind CrN (Chromnitrid) Legierungen, die im PVD-Prozess zumindest bereichsweise auf der Walze appliziert werden können, da sie hervorragende Verschleiß-, Korrosions- und Abriebeigenschaften aufweisen, dazu chemisch stabil sind und eine hohe Härte bereitstellen. Der Einsatz derartiger Beschichtungen ist in der Kunststoffverarbeitung weit verbreitet. Um der Verschleißschutzschicht eine verbesserte Zähigkeit verleihen zu können, wird Vanadium zugeführt, so dass eine CrVN (Chromvanadiumnitrid) Legierung zum Einsatz kommen kann, beispielsweise in einem Verhältnis V zu Cr + V zwischen 0,1 und 0,7, insbesondere zwischen 0,11 und 0,55, vorzugsweise zwischen 0,13 und 0,45.

Die Verschleißschutzschicht umfassend eine CrN- oder CrVN-Legierung kann ein (Mindest-)Härte von 1200 HV0,01 bis zu 2800 HV0,01 aufweisen.

Die Verschleißschutzschicht kann gemäß einer alternativen Ausführung mittels HVOF appliziert sein. Der HVOF-Prozess ist als solcher ebenfalls bekannt und damit Stand der Technik, vgl. auch WO 2021/148690 A1 und EP 3 394 311 B1. Als besonders geeignet sind WC, bevorzugt WCCo-Beschichtungen, die im HVOF-Prozess zumindest bereichsweise auf der Walze appliziert werden können, da sie hervorragende Verschleiß- und Abriebeigenschaften aufweisen, dazu auch eine hohe Härte bereitstellen. Diese Schichten bestehen aus WC (Wolframcarbid)-Partikel mit Co (Cobalt) als Bindemittel.

Die Verschleißschutzschicht, umfassend eine WC- oder WCCo-Legierung, kann eine (Mindest-)Härte von 900 HV0,01 bis zu 2000 HV0,01 aufweisen.

Die Oberfläche bzw. Oberflächenstruktur der Verschleißschutzschicht weist beispielsweise eine schuppig erscheinende Oberfläche auf, welche insbesondere positive Eigenschaften im Walzprozess haben kann. So zum Beispiel kann durch diese Oberflächen-Struktur eine im Walzprozess zur Schmierung erforderliche Emulsion optimal über die Walze verteilt werden. Das mit dieser Oberfläche gewalzte und abgeprägte Material beeinflusst die Emulsionsschmierung durch Mitführen der Emulsion in den Vertiefungen der schuppigen Struktur weiterhin positiv, da Emulsion gezielt und gleichmäßig mit in den Walzspalt geführt wird. Mithin kann die Emulsionszusammensetzung angepasst werden, da die Schmierung im Walzspalt aus oben genannten Gründen verbessert ist, kann der insbesondere zur Schmierung derzeit notwendige Walzöl-Anteil der Emulsion abgesenkt werden. Dadurch kann eine kostengünstige und umweltverträgliche Emulsion bereitgestellt werden, so dass mit dem so erhöhten Wasseranteil der Emulsion die Reinigungswirkung zunehmen und die Bandsauberkeit maßgeblich verbessert werden kann. Ein weiterer Aspekt zur Absenkung des Walzölanteils in der Emulsion ist die Absenkung der Rauheit. Dadurch kann auch die Temperaturentwicklung im Walzspalt und der Öl-Anteil, der zur Kühlung benötigt wird, absenkt werden.

Die zumindest bereichsweise mit einer Verschleißschutzschicht der vorgenannten Art beschichteten Walzen ermöglichen durch einen höheren Reibbeiwert (oder auch Reibkoeffizient) im Walzprozess insbesondere bei gleicher Walzen-Rauheit mehr Walzkraft zu übertragen. Dies kann dazu führen, dass bei gleicher Verformung/bei gleichen Umformgraden weniger Walzkraft benötigt wird und somit eine Erweiterung des walzbaren Produktportfolios ebenso wie Energieeinsparungen durch Motorstromeinsparungen ermöglicht wird.

Weiterhin ist davon auszugehen, dass sich die zumindest bereichsweise mit einer Verschleißschutzschicht der vorgenannten Art beschichteten Walzen positiv auf eine Abplattung der Walze im Walzprozess auswirken kann. Die Abplattung kann als Vergrößerung der Kontaktfläche durch die Verformung der Walze im Kontaktbereich definiert werden. So kann eine erhöhte Standzeit erreicht werden, da der Verschleiß der Rauheit an der Walze sinkt und diese somit länger im Einsatz bleiben kann. Eine geringere Abplattung der Walze hat außerdem eine geringere Temperaturentwicklung zur Folge und kann damit insbesondere eine notwendige Kühlung absenken. Zudem hat eine verringerte Abplattung der Walze weitere positive Eigenschaften, wie zum Beispiel ein reduziertes Auffedern eines Gerüstes im Prozess, so dass daraus resultierend ein gleichmäßigerer Dickenschrieb und eine höhere Maßhaltigkeit möglich ist.

Die zumindest bereichsweise mit einer Verschleißschutzschicht der vorgenannten Art beschichteten Walzen können die Resistenz gegen Fehler und Schädigungen verbessern und/oder erhöhen. Eine schlagartige Belastung auf der Walze durch beispielsweise quer verlaufende Schweißnähte durch das Zusammenführen von Metallbändern insbesondere im Kaltwalzprozess, Fehler im Material oder Anstich kann durch die zumindest bereichsweise applizierte Verschleißschutzschicht der vorgenannten Art aufgenommen werden und gleichmäßig verteilt werden, ohne dass es zu einer Schädigung der Walze und/oder Beschichtung kommt. Des Weiteren kann sich die hohe Härte der Verschleißschutzschicht positiv auf Resistenz gegen Walzfehler auswirken. Es ist mithin davon auszugehen, dass die zumindest bereichsweise mit einer Verschleißschutzschicht der vorgenannten Art beschichteten Walzen eine höhere Beständigkeit gegen Schlag- und/oder Stoßbelastung aufweisen. Weiterhin ist durch die Härte und die Verteilung von Belastung durch die Beschichtung von einer Rissbeständigkeit auszugehen. Ein positiver Effekt neben der längeren Standzeit und Haltbarkeit der Walze ist, dass keine Geschwindigkeitsdrosselung im Prozess bei Materialfehlern notwendig ist und somit eine höhere Produktivität des Prozesses erreicht werden kann.

Durch die Oberflächenenergie der beschriebenen Verschleißschutzschicht, des verbesserten Reibbeiwertes, der verbesserten Schmierung im Walzspalt und der damit möglichen verbundenen anderen Temperatur im Walzspalt ist davon auszugehen, dass ein Materialfehler, der eine Ablösung von Walzgut zur Folge haben kann, nicht an der Walze haften bleibt und somit kein Material an die Zwischen- bzw. Stützwalzen transportiert wird und diese nicht beschädigt werden. Dadurch unterliegt auch die Peripherie um die Walze einer entsprechenden Standzeit.

Die erfindungsgemäße Walze findet Verwendung in mindestens einem Gerüst eines Warmwalzwerks oder Kaltwalzwerks, oder auch eines Nachwalz- oder Dressierwerks.

Das Warmwalzwerk kann dabei vier, fünf, sechs, sieben, acht oder neun Gerüste umfassen.

Das Kaltwalzwerk kann dabei ein(s), beispielsweise ein Reversiergerüst, zwei, beispielsweise ein Doppelreversiergerüst, drei, vier, fünf oder sechs Gerüste umfassen.

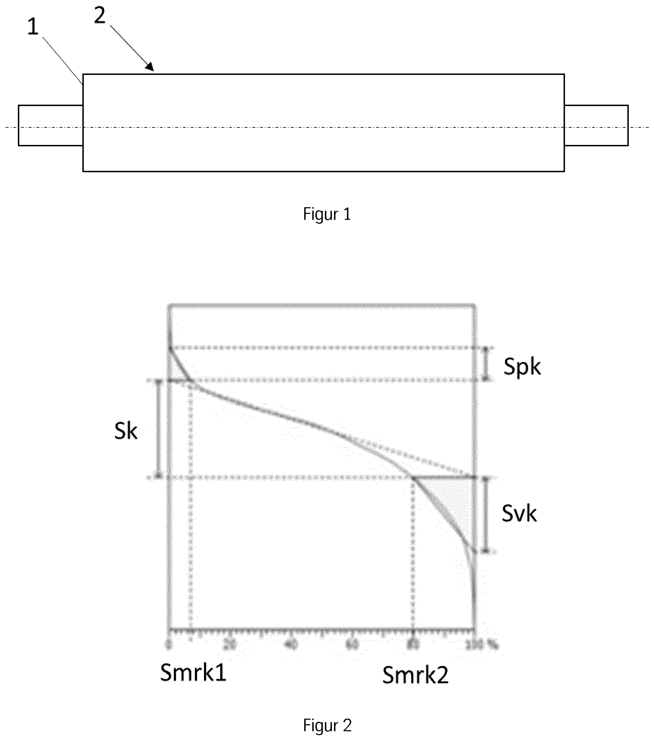

Eine beispielhafte Ausführung einer erfindungsgemäßen Walze (1) mit einer zumindest bereichsweise applizierten Verschleißschutzschicht (2) mit einer Mindesthärte von 700 HV0,01 ist schematisch in einer Schnittansicht in **Figur 1** dargestellt. Die Verschleißschutzschicht (2) kann eine Dicke zwischen 3 und 350 µm aufweisen. Die Verschleißschutzschicht (2) auf der Walze (1) kann entweder mittels PVD, wobei sie eine CrN-Legierung, mit vorzugsweise zusätzlich V umfassen kann, oder mittels HVOF, wobei sie bevorzugt eine WCCo-Beschichtung umfassen kann, appliziert sein.

Die Oberfläche der Verschleißschutzschicht (2) weist einen Spk > 1,20 µm und einen Svk > 1,20 µm auf, ermittelt nach DIN EN ISO 25178-2:2023-09. Derartige erfindungsgemäße Walzen (1) können in mindestens einem nicht dargestellten Gerüst eines Warmwalzwerkes, welches vier bis neun Gerüste umfassen kann, oder eines Kaltwalzwerkes, welches eins bis sechs Gerüste, wobei das Kaltwalzwerk auch nur ein Reversiergerüst oder ein Doppelreversiergerüst umfassen kann, Verwendung finden, beispielsweise auch in einem Gerüst eines Nachwalz- oder Dressierwerks.

**Figur 2** zeigt ein Beispiel einer Materialanteilkurve, auch Abbott-Firestone-Kurve bezeichnet, mit einem Wendepunkt, somit eine S-förmige Materialanteilkurve, ermittelt nach DIN EN 25178-2:2023-09, welche von der Mantelfläche der Walze (1) vor dem Beschichten erfasst worden ist.

In einer Untersuchung wurden Walzen (1), welche gewöhnlich in Gerüsten eines Kaltwalzwerkes Verwendung finden, bereitgestellt, die alle eine bearbeitete Mantelfläche hatten, welche eine S-förmigen Materialanteilkurve aufwiesen. Erfasst wurde die Materialkurve mittels eines µ-surf Weißlichtinterferometer-3D-Mikroskops und einer dahinterliegenden Bildverarbeitungssoftware in Anlehnung bzw. unter Berücksichtigung der DIN EN ISO 25178-2:2023-09. Es wurden vier Walzen (1) mit unterschiedlichen Verschleißschutzschichten (2) mittels unterschiedlichen Applikationsverfahren vollflächig auf der Mantelfläche der Walze mit im Wesentlichen identischer Dicke beschichtet.

Die Verfahren/Beschichtungen waren:
I Standard-Variante für Walzen, Hartverchromung mittels elektrolytischer Abscheidung;
II Fe, 1% C, 0,3% Si, 4% Cr, 5% Mo, 0,3% Mn, 2% V, 6,2% W mittels Hochgeschwindigkeit-Laserauftragsschweißen;
III CrVN mit V/(Cr + V) von 0,13 mittels PVD;
IV WCCo mit 12 Gew.-% Co mittels thermischen Spritzen.

Nachdem die Walzen (1) mit einer Verschleißschutzschicht beschichtet worden sind, wurden die Verschleißschutzschicht (2) mittels Weißlichtinterferometer-3D-Mikroskop erfasst, wobei an jeder Walze (1) mehrere Bereiche untersucht worden sind. Die charakteristischen Eigenschaften der jeweiligen Beschichtungen, wobei die Ergebnisse aus den einzelnen Bereichen jeweils zusammengefasst und als Mittelwert angegeben sind, sind der Tabelle 1 zu entnehmen.

**Tabelle 1**

| Schicht | Sa [µm] | Spd [1/cm2] | Sp [µm] | Sv [µm] | Sz [µm] | St [µm] | Spk [µm] | Svk [µm] | Smrk1 [%] | Smrk2 [%] |
|---|---|---|---|---|---|---|---|---|---|---|
| I | 0,24 | 386,91 | 1,09 | -3,33 | 4,42 | 7,45 | **0,28** | **0,88** | 10 | 87,75 |
| II | 0,26 | 1115,56 | 0,97 | -1,41 | 2,38 | 3,66 | **0,23** | **0,44** | 7,79 | 87,07 |
| III | 3,21 | 7282,92 | 12,11 | -11,45 | 23,56 | 33,36 | 4,26 | 4,29 | 8,33 | 88,54 |
| IV | 1,94 | 8981,35 | 6,58 | -6,72 | 13,3 | 16,08 | 2,22 | 2,21 | 9,69 | 90,14 |

Obwohl die Grundvoraussetzung der Walzen (1) mit jeweils einer Mantelfläche mit einer S-förmigen Materialanteilkurve vorlag, konnten überraschend nur bei der PVD-Variante und beim thermischen Spritzen die vorteilhaften Oberflächeneigenschaften der Verschleißschutzschicht (2) hergestellt bzw. bereitgestellt werden.

## Patentansprüche

1. Walze (1) mit einer zumindest bereichsweise applizierten Verschleißschutzschicht (2) mit einer Mindesthärte von 700 HV0,01, **dadurch gekennzeichnet, dass** die Oberfläche der Verschleißschutzschicht (2) charakteristische Kenngrößen mit Spk > 1,20 µm und Svk > 1,20 µm aufweist, ermittelt nach DIN EN ISO 25178-2:2023-09.

2. Walze nach Anspruch 1, wobei die Walze (1) eine Mantelfläche umfasst, welche eine S-förmige Materialanteilkurve aufweist, ermittelt nach DIN EN ISO 25178-2:2023-09.

3. Walze nach einem der vorhergehenden Ansprüche, wobei die Verschleißschutzschicht (2) eine Dicke zwischen 3 und 350 µm aufweist.

4. Walze nach einem der vorhergehenden Ansprüche, wobei die Verschleißschutzschicht (2) mittels PVD appliziert ist.

5. Walze nach Anspruch 4, wobei die Verschleißschutzschicht (2) eine CrN-Legierung umfasst.

6. Walze nach Anspruch 5, wobei die Verschleißschutzschicht (2) V zusätzlich umfasst.

7. Walze nach Anspruch 5 oder 6, wobei die Verschleißschutzschicht (2) eine Mindesthärte von 1200 HV0,01 aufweist.

8. Walze nach einem der Ansprüche 1 bis 3, wobei die Verschleißschutzschicht (2) mittels HVOF appliziert ist.

9. Walze nach Anspruch 8, wobei die Verschleißschutzschicht (2) eine WCCo-Beschichtung umfasst.

10. Walze nach Anspruch 9, wobei die Verschleißschutzschicht (2) eine Mindesthärte von 900 HV0,01 aufweist.

11. Verwendung einer Walze (1) nach einem der Ansprüche 1 bis 10 in mindestens einem Gerüst eines Warmwalzwerks, Kaltwalzwerks, Nachwalzwerks oder Dressierwerks.

12. Verwendung nach Anspruch 11 in einem Warmwalzwerk umfassend vier bis neun Gerüste.

13. Verwendung nach Anspruch 11 in einem Kaltwalzwerk umfassend eins bis sechs Gerüste.

14. Verwendung nach Anspruch 13 in einem Reversiergerüst oder einem Doppelreversiergerüst.
